Europäisches Patentamt

European Patent Office

Office européen des brevets

(11) Veröffentlichungsnummer: **0 313 132**
**A2**

# EUROPÄISCHE PATENTANMELDUNG

(21) Anmeldenummer: 88202194.2

(22) Anmeldetag: 04.10.88

(51) Int. Cl.⁴: **G01R 33/035**

(30) Priorität: 22.10.87 DE 3735668

(43) Veröffentlichungstag der Anmeldung:
**26.04.89 Patentblatt 89/17**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB**

(72) Erfinder: **Dössel, Olaf, Dr.**
**Grosse Twiete 3b**
**D-2081 Tangstedt(DE)**

(74) Vertreter: **Auer, Horst, Dipl.-Ing. et al**
**Philips Patentverwaltung GmbH**
**Wendenstrasse 35 Postfach 10 51 49**
**D-2000 Hamburg 1(DE)**

(54) **Vorrichtung zur mehrkanaligen Messung schwacher Magnetfelder.**

(57) Die Erfindung bezieht sich auf eine Vorrichtung zur mehrkanaligen Messung schwacher Magnetfelder mit einer jedem Kanal zugeordneten, auf einem Grundträger (30) angebrachten Anordnung aus einem DC-SQUID (6, 27), aus einer Gradiometerspule (8, 12, 15, 16, 37), aus einer Einkoppelspule (9, 19, 38), aus supraleitenden Verbindungsleitungen (10, 17, 18, 41) und aus einer Modulationsspule (7, 26). Die Gradiometerspule, die Einkoppelspule und das SQUID sind aus Dünnfilmstrukturen gebildet. Zur Auswertung der von den SQUIDS in jedem Kanal erzeugten Signale dient eine Auswerteeinrichtung (11). Für jeden Kanal ist eine gesonderte Platte (29) vorgesehen, auf der das SQUID und die Modulationsspule aufgebracht sind. Die für jeden Kanal vorgesehene Anordnung aus Gradiometerspule, Verbindungsleitungen und Einkoppelspule ist auf einem gesonderten Gradiometerträger (12, 32) aufgebracht. Eine Platte ist auf einem Gradiometerträger angeordnet und die einzelnen Gradiometerträger sind mit dem Grundträger verbunden.

Fig. 2

## Vorrichtung zur mehrkanaligen Messung schwacher Magnetfelder

Die Erfindung bezieht sich auf eine Vorrichtung zur mehrkanaligen Messung schwacher Magnetfelder mit einer jedem Kanal zugegeordneten, auf einem Grundträger angebrachten Anordnung aus einem supraleitenden Quanten-Interferenz-Element (SQUID), aus einem durch mindestens eine zur Erfassung des magnetischen Feldes dienenden Gradiometerspule, aus mindestens einer zur Einkopplung des Feldes in das SQUID dienenden Einkoppelspule, aus supraleitenden Verbindungsleitungen zwischen Gradiometerspule und Einkoppelspule und aus einer Modulationsspule, wobei wenigstens die Gradiometerspule, die Einkoppelspule und das SQUID aus Dünnfilmstrukturen gebildet sind, und mit einer zur Auswertung der von den SQUIDS in jedem Kanal erzeugten Signale dienenden Auswerteeinrichtung.

Zur Messung schwacher Magnetfelder in einem Feldstärkebereich unter $10^{-10}$ Tesla werden supraleitende Quanten-Inerferenz-Elemente verwendet, die als SQUIDS (Superconducting Quantum Interference Devices) bezeichnet werden. Die SQUIDS dienen in der Medizintechnik zur Messung der Magnetfelder des Herzens oder des Gehirns (Magnetokardiographie, Magnetoenzephalographie) oder auch zur Leberdiagnostik (Lebersuszeptometrie).

Eine Vorrichtung zur Messung solcher schwacher Magnetfelder enthält ein Gradiometer, eine Einkoppelspule, ein SQUID, eine Modulationspule, Verstärker und eine Auswerteeinrichtung. Das Gradiometer, die Einkoppelspule, das SQUID und die Modulationsspule sind zusammen in einem Kryosystem für den Tieftemperaturbereich zur Herstellung der Supraleitung untergebracht. Die Gradiometerspule erfaßt das zu messende Magnetfeld, welches von einer kleineren am SQUID angeordneten Einkoppelspule in das SQUID transformiert wird. Gradiometer und Einkoppelspule bilden einen geschlossenen supraleitenden Stromkreis. Bei der Messung solcher Magnetfelder werden sowohl RF-SQUIDS (Hochfrequenz- oder Radio-Frequency-SQUIDS) als auch DC-SQUIDS (Gleichstrom- oder Direct-Current-SQUIDS) eingesetzt.

Das DC-SQUID besteht aus einer geschlossenen supraleitenden Schleife, die von zwei Josephson-Kontakten unterbrochen wird. Zwischen den Josephson-Kontakten ist ein nicht-supraleitender Gleichstromanschluß vorgesehen. Die Spannung zwischen den Anschlüssen müßte abhängig vom eingekoppelten Magnetfeld variieren, wenn diese nicht mittels der Modulationsspule, die ein entgegengesetztes Magnetfeld erzeugt, weitgehend konstant gehalten wird (flux-locked-loop). Aus dem Strom, der für die Modulationsspule benötigt wird, wird auf die Größe des äußeren Magnetfeldes geschlossen. Dabei wird mittels der Modulationsspule ein hochfrequentes Feld dem zu messenden Feld überlagert. Der Verstärker verstärkt nur Signale, die der Frequenz und der Phasenlage des Hochfrequenzfeldes entsprechen (Lock-in-Technik).

Um eine räumliche Feldverteilung zu erhalten, werden um die Meßstelle mehrere SQUIDS mit zugeordnetem Gradiometer angeordnet, deren Meßsignale über mehrere Kanäle zu einer Auswerteeinheit geführt werden.

Die eingangs genannte Vorrichtung zur Messung schwacher Magnetfelder ist aus der EP-PS 0 111 827 bekannt. Auf einem Grundträger, einer Quarz- oder Siliziumplatte, sind in Dünnschichttechnik die für jeden Meßkanal vorgesehenen Gradiometerspulen und die Verbindungsleitungen aufgebracht. Die SQUIDS befinden sich mit den Einkoppelspulen auf einem weiteren Träger. Die notwendigen supraleitenden Verbindungen zwischen den Gradiometern und den Einkoppelspulen werden durch Lötungen realisiert. Eine solche Vorrichtung kann häufig aufgrund von defekten Lötstellen ausfallen, die bedingt sind durch Alterungseffekte und durch den großen Temperaturunterschied zwischen Herstellung und Meßbetrieb. Die Gradiometerspulen sind unveränderbar nebeneinander so angeordnet, daß sie ein bestimmtes Magnetfeld erfassen können.

Eine Vorrichtung, die z.B. zur Messung der Magnetfelder des Kopfes dienen soll, erfordert einen Grundträger mit einer bogenförmigen Oberfläche. Die Herstellung einer solchen Vorrichtung ist kompliziert.

Der Ausfall eines SQUIDS oder einer Gradiometerspule führt zum Ausfall der gesamten Vorrichtung, da der Austausch einer einzelnen Gradiometerspule bzw. eines einzelnen SQUIDS nicht möglich ist. Ebenso ist es nicht möglich, die Gradiometerspulen bzw. die SQUIDS nachträglich anders anzuordnen, z.B. von einem Grundträger mit einer ebenen Oberfläche auf einen Grundträger mit einer bogenförmigen Oberfläche.

Der Erfindung liegt daher die Aufgabe zugrunde, eine Vorrichtung zur mehrkanaligen Messung schwacher Magnetfelder zu schaffen, die auf einfache Weise herstellbar, unterschiedlichen Formen anpaßbar und mit einfach austauschbaren Elementaranordnungen versehen ist.

Diese Aufgabe wird bei einer Vorrichtung der eingangs genannten Art dadurch gelöst, daß für jeden Kanal eine gesonderte Platte vorgesehen ist, auf der das SQUID und die Modulationsspule aufgebracht sind, daß die für jeden Kanal vorgesehene Anordnung aus Gradiometerspule, Verbindungsleitungen und Einkoppelspule auf jeweils einem gesonderten Gradiometerträger aufgebracht ist und daß eine Platte auf einem Gradiometerträger angeordnet ist und die einzelnen Gradiometerträger mit dem Grundträger verbunden sind.

Bei der erfindungsgemäßen Vorrichtung sind die Gradiometerspulen und die Verbindungsleitungen nicht direkt in Dünnschichttechnik auf dem Grundträger aufgebracht, sondern es sind jeweils ein Gradiometer mit mindestens einer Spule und eine Einkoppelspule mit den erforderlichen Verbindungsleitungen für einen Kanal auf einem Gradiometerträger, der z.B. würfelförmig ausgebildet ist, in Dünnschichttechnik aufgebracht. Eine Platte mit dem SQUID und der Modulationsspule für einen Kanal sind über der Einkoppelspule angebracht. Solche Gradiometerträger können dann auf einfache Weise auf einem beliebig geformten Grundträger angeordnet werden. Vorzugsweise sollte bei der Herstellung der Gradiometerträger so vorgegangen werden, daß diese zunächst zu einem Block zusammengefaßt und gemeinsam beschichtet werden. Vor der Trennung werden die erforderlichen Dünnschichtschaltungen für die Gradiometerspulen gebildet. Auf ähnliche Art ist die Herstellung der SQUIDS möglich, die nach der Vereinzelung auf dem Gradiometerträger befestigt werden. Durch diese Art des Aufbaues sind zwischen den einzelnen Trägern bzw. der Platte keine weiteren supraleitenden Verbindungen mehr herzustellen.

Um den Austausch von defekten SQUIDS bzw. Gradiometerspulen zu vereinfachen, ist vorgesehen, daß die Platte lösbar mit dem Gradiometerträger und die Gradiometerträger lösbar mit dem Grundträger verbunden sind. Vorzugsweise sind die lösbaren Verbindungen Klebeverbindungen. Diese Klebeverbindungen können durch den Angriff einer mechanischen Kraft an einer bestimmten Stelle oder durch ein geeignetes Lösungsmittel gelöst werden.

Ein einfach herzustellender Gradiometerträger ergibt sich bei Verwendung eines Gradiometers erster oder höherer Ordnung, wenn die Gradiometerspulen, die einen gemeinsamen Wicklungssinn haben, auf einer Basisfläche des Gradiometerträgers und die Gradiometerspulen mit gegensinnigem Wicklungssinn auf einer gegenüberliegenden Basisfläche des Gradiometerträgers angeordnet sind. Durch die gegensinnig gewickelten Spulen des Gradiometers wird eine Kompensation des Erdmagnetfeldes und anderer homogener Störmagnetfelder erreicht.

In einer Weiterbildung der Erfindung ist vorgesehen, daß die Einkoppelspule auf einer die Basisflächen verbindenden Seitenfläche des Gradiometerträgers angeordnet ist.

Ein solcher Teilträger wird hergestellt, indem zunächst auf gegenüberliegenden Basisflächen des Gradiometerträgers die Gradiometerspulen und auf einer Seitenfläche die Verbindungsleitungen und die Einkoppelspule photolithographisch angebracht werden und anschließend nach Aufbringen einer Isolationsschicht auf die Seitenfläche eine Platte, welche das in Photolithographie-Technik aufgebrachte SQUID und die Modulationsspule enthält, aufgeklebt wird.

Die Verbindungsleitungen, die an den Kanten zwischen den Basisflächen und der Seitenfläche verlaufen, können z.B. über abgeschrägte Kanten in Nuten verlaufen. Diese Verbindungsleitungen können anschließend mit supraleitendem Material für eine verbesserte Verbindung verlötet werden, wie das in der EP-PS 0 111 827 beschrieben ist. Eine andere Möglichkeit besteht darin, in Kerben an den Kanten für jede Verbindungsleitung supraleitende Drähte einzusetzen, auf die anschließend nach Polierung Dünnschichtleitungen aufgebracht werden. Hierbei ist eine Verlötung an den Kanten nicht erforderlich.

In einer anderen Weiterbildung der Erfindung ist vorgesehen, daß die Einkoppelspule auf einer Basisfläche des Gradiometerträgers angebracht ist, auf der eine feldseitige Gradiometerspule angeordnet ist. Hierbei müssen nur auf zwei Flächen des Teilträgers Dünnschichtleitungen angebracht werden. Die Verbindungsleitungen zwischen den Gradiometerspulen sind supraleitende Drähte, die in Nuten einer Seitenfläche des Gradiometerträgers verlaufen, welche die beiden gegenüberliegenden Basisflächen mit den Gradiometerspulen verbindet.

Ein solcher Gradiometerträger ist herstellbar, indem zunächst in eine Seitenfläche des Körpers Nuten geschnitten werden und in diese Nuten supraleitende Drähte eingebracht werden, daß anschließend nach Polierung der beiden gegenüberliegenden die Seitenfläche mit den Nuten verbindenden Basisflächen die Gradiometerspulen photolithographisch aufgebracht werden und daß nach Aufbringen einer Isolationsschicht auf die Basisflächen eine Platte, welche das in Photolithographie-Technik aufgebrachte SQUID und die Modulationsspule enthält, aufgeklebt wird. Die Zuverlässigkeit einer nach diesem Verfahren hergestellten Vorrichtung ist größer als die der bekannten Vorrichtung, da sie keine einzige Lötstelle aufweist. Die Anschlüsse der normalleitenden Verbindungen, die zu den Verstärkern und der Auswerteeinheit führen, werden durch das zuverlässige Bonden an das SQUID angebracht.

Zur Erzielung einer guten Kompensation von homogenen Magnetfeldern ist vorgesehen, daß auf der keine Einkoppelspule aufweisenden Basisfläche eine der Einkoppelspule gegenüberliegende supraleitende Leitungsstruktur aufgebracht ist, die im wesentlichen der Struktur der Einkoppelspule entspricht.

Bei der Erfassung eines magnetischen Feldes ist es vorteilhaft, wenn die Meßvorrichtung eine möglichst große Anzahl von Kanälen auf der vorgegebenen Kreisfläche des Kryostatenbodens aufweist. Bei Verwendung von Gradiometerträgern, die einen sechseckigen Querschnitt aufweisen, ist es möglich, besonders viele Meßkanäle auf einer vorgegebenen Kreisfläche anzuordnen.

Supraleitende Abschirmungen gegen störende Felder werden auf einfache Art zwischen Gradiometerträger und Einkoppelspule und auf der Seite der Platte, die dem Gradiometerträger abgewendet ist, angeordnet.

Ausführungsbeispiele der Erfindung werden nachstehend anhand der Zeichnungen näher erläutert. Es zeigen:

Fig. 1 die schematische Darstellung eine Vorrichtung zur Messung schwacher Magnetfelder, und zwar Fig. 1a ein Schaltschema und Fig. 1b eine Einrichtung zur Erfassung des Magnetfeldes,

Fig. 2 ein erstes Ausführungsbeispiel eines Gradiometerträgers in auseinandergezogenem Zustand,

Fig. 3 auf einem Grundträger befestigte Gradiometerträger und

Fig. 4 ein zweites Ausführungsbeispiel eines Gradiometerträgers.

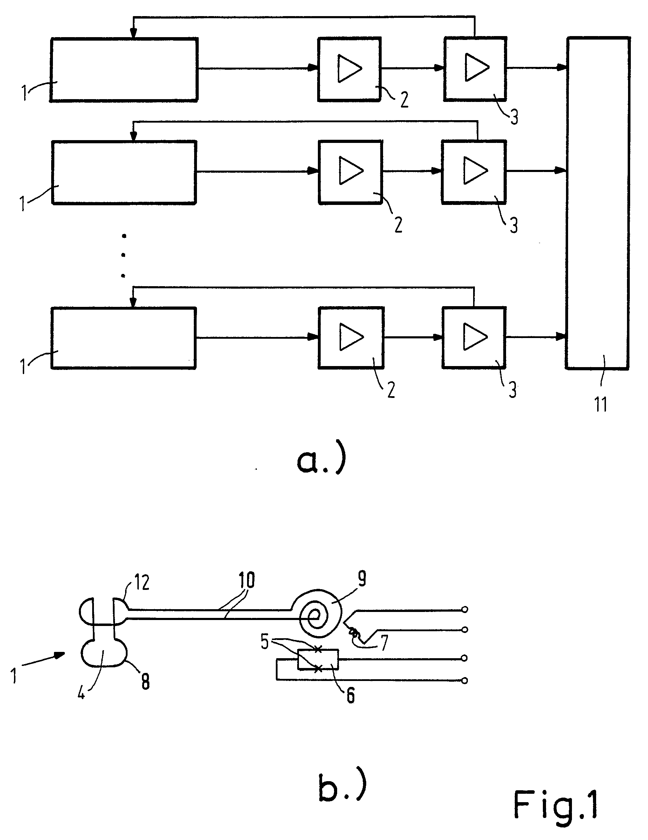

In Fig. 1a ist ein Schaltungsschema einer Vorrichtung zur Messung schwacher Magnetfelder dargestellt, die eine Anzahl paralleler Meßkanäle aufweist. Jeder Kanal enthält eine Einrichtung 1 zur Erfassung des Magnetfeldes, einen Vorverstärker 2 und einen Lock-In-Verstärker 3. Die Einrichtung 1 (Fig. 1b) besteht aus einem supraleitenden Gradiometer 4, einer supraleitenden Einkoppelspule 9, supraleitenden Verbindungsleitungen 10, einem mit zwei Josephson-Kontakten 5 ausgestatteten supraleitenden Gleichstrom-Quanten-Interferenz-Element 6 (DC-SQUID) und einer supraleitenden Modulationsspule 7. Das Gradiometer 4 enthält zwei Spulen 8 und 12 zur Erfassung des zu messenden magnetischen Feldes. Die Einkoppelspule 9 dient zur Transformierung des erfaßten magnetischen Feldes in das SQUID 6. Die Spulen 8, 9 und 12 sind durch Verbindungsleitungen 10 miteinander verbunden. Die zwischen den Josephson-Kontakten 5 liegenden Anschlüsse des SQUIDS 6 sind mit normal leitenden Verbindungen verbunden, die zum Vorverstärker 2 führen. Der dem Vorverstärker 2 zugeführte Gleichspannungsanteil wird mit Hilfe der von dem Lock-In-Verstärker 3 gesteuerten Modulationsspule 7 im wesentlichen konstant gehalten. Der Lock-In-Verstärker 3 leitet einer Auswerteeinheit 11 ein Signal zu, das aus dem Steuersignal der Modulationsspule 7 abgeleitet ist. In der Auswerteeinheit 11 wird aus den verschiedenen in den Kanälen erzeugten Signalen ein Maß für das gesamte von den Kanälen erfaßte magnetische Feld gebildet.

Die für jeden Kanal vorgesehene Einrichtung 1 mit Gradiometer 4, Einkoppelspule 9, SQUID 6 und Modulationsspule 7 ist in einem Kryosystem zur Erzeugung der Supraleitfähigkeit untergebracht. Die jeweiligen Einrichtungen 1 sind dabei auf einem gemeinsamen Grundträger untergebracht. Der Grundträger kann z.B. zur Messung des Magnetfeldes eines Kopfes eine bogenförmige Oberfläche aufweisen oder zur Messung des Herzmagnetfeldes eine ebene Oberfläche. Auf dem Grundträger sind Gradiometerträger untergebracht, die ein Gradiometer 4, eine Einkoppelspule 9, ein SQUID 6 und eine Modulationsspule 7 aufweisen.

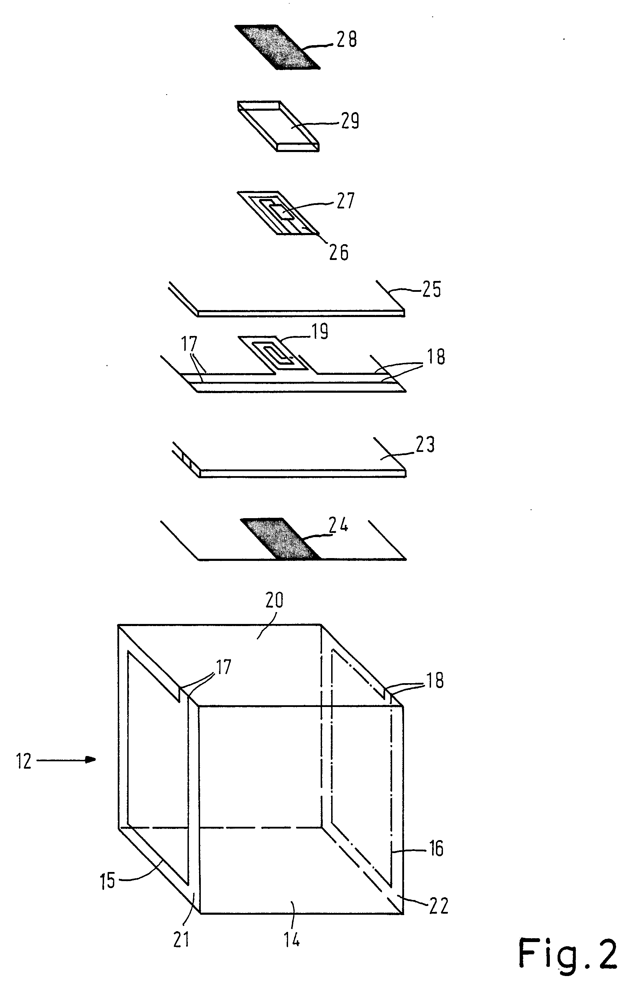

Ein erstes Ausführungsbeispiel für einen Gradiometerträger 12, der einen würfelförmigen Grundkörper 14 aufweist, ist in Fig. 2 dargestellt. Der Körper 14 kann beispielsweise aus Glas, Quarz oder Silizium bestehen. Auf zwei gegenüberliegenden Basisflächen 21 und 22 des Körpers 14 sind Gradiometerspulen 15 und 16 mit entgegengesetztem Wicklungssinn aufgebracht. Eine solche Spulenanordnung dient zur Kompensation homogener Magnetfelder, z.B. des Erdmagnetfeldes. Die Spulen 15 und 16 können beispielsweise einen quadratförmigen Verlauf haben und eine Kantenlänge von 2 cm aufweisen. Auf einer Seitenfläche 20, die die beiden Basisflächen 21 und 22 verbindet, ist eine Einkoppelspule 19 aufgebracht. Die Gradiometerspulen 15 und 16 sind mit der Einkoppelspule 19 über Verbindungsleitungen 17 und 18 gekoppelt. Die Spule 19 kann auf der Seitenfläche 20 beispielsweise zentrisch angeordnet werden. Zwischen der Spule 19 und der Seitenfläche 20 ist noch eine supraleitende Abschirmung 24 und eine Isolationsschicht 23, z.B. aus Siliziumoxid, angeordnet.

Auf der Spule 19 ist getrennt durch eine Isolationsschicht 25 aus z.B. Siliziumoxid, eine Platte 29 mit dem DC-SQUID 27 und der Modulationsspule 26 aufgebracht. Zur Abschirmung ist eine weitere supraleitende Schicht 28 auf der Seite der Platte 29 angebracht, auf der nicht das DC-SQUID aufgebracht ist. Die Platte 29 wird auf der Isolationsschicht 25 durch Kleben angebracht. Hierbei soll ein Klebstoff, z.B. Araldit, UHU-plus, oder ein Lack mit der Bezeichnung GE-7031, verwendet werden, bei dem durch Angriff einer mechanischen Kraft an einer geeigneten Stelle oder mit einem geeigneten Lösungsmittel die Platte 29 von der Isolationsschicht 25 gelöst werden kann.

Bei der Herstellung eines Gradiometerträgers 12 werden zunächst die Gradiometerspulen 15 und 16 in einem an sich bekannten photolithographischen Schritt in Form von supraleitenden Dünnschicht-Spulen realisiert. Anschließend wird auf die Seitenfläche 20 zuerst die Abschirmung 24, dann die Isolationsschicht 23 und anschließend die Spule 19 und die Verbindungen 17 und 18 aufgebracht. Auf die Isolationsschicht 23 mit den supraleitenden Verbindungen 17 und 18 und der supraleitenden Spule 19 wird die Isolationsschicht 25 aufgebracht, auf der dann die vorher hergestellte Platte 29 aufgeklebt wird. Auf die Platte 29 sind auf der einen Seite ebenfalls in Photolithographie-Technik die Modulationsspule 26 und das SQUID 27 aufgebracht worden und auf der anderen Seite die Abschirmung 28. Die Spulen 15, 16 und 19, die Verbindungsleitungen 17 und 18 und die Abschirmungen 24 und 28 bestehen beispielsweise aus Niob-Dünnfilmen. Die Isolationsschichten 23 und 25 können durch Aufdampfen von Siliziumoxid, durch Aufschlendern eines Sol-Gels mit anschließender Ausheizprozedur oder in Dickschichttechnik hergestellt werden. Das SQUID 27 besteht z.B. aus Niobnitrid mit dünnen Isolatorschichten aus Magnesiumoxid.

Nach der Herstellung des Gradiometerträgers wird ein einmaliger Abgleich der Gradiometerspulen 15 und 16 vorgenommen. Hierzu kann insbesondere ein Laserstrahl verwendet werden, mit dem die Breite der einzelnen Spulenwindungen zu verringern ist. Der Abgleich erfolgt zweckmäßig nach Testmessungen in homogenen Magnetfeldern und homogenen Gradientenfeldern.

Die Verbindungsleitungen 17 und 18 können an den Kanten zwischen den Flächen 21 und 20 und 22 und 20 gemäß dem in der EP-PS 0 111 827 beschriebenen Verfahren hergestellt werden. Hierbei wird nach Abschrägung der Kante und Aufbringung der Dünnschichtleitungen eine Verlötung der Verbindungen vorgesehen. Es können aber auch vor der Herstellung der Gradiometerspulen 15 und 16 in Kerben an den Kanten supraleitende Drähte eingesetzt werden, auf die dann die Verbindungsleitungen 17 und 18 in Dünnschicht-Technik aufgebracht werden. Bevor die Dünnschicht aufgebracht wird, muß der Körper 14 mit den eingebrachten Drähten poliert werden. Anschließend kann die Verbindung ohne Verlötung hergestellt werden.

Bevor die Platte 29 auf dem Gradiometerträger 14 angebracht wird, werden normal leitende Verbindungen, die zu den Verstärkern 2 und 3 führen, durch Bonden an die Anschlüsse zwischen den Josephson-Kontakten angebracht.

Vorzugsweise sollte bei der Herstellung der Gradiometerträger 12 so vorgegangen werden, daß zuerst mehrere Gradiometerträger zu einem Block zusammengefaßt werden und dann Spulen 15 und 16 in Dünnschicht-Technik aufgebracht werden. Anschließend werden die Gradiometerträger aus dem Block getrennt. Die Gradiometerträger 12 müssen danach auf der Seitenfläche 20 noch beschichtet werden.

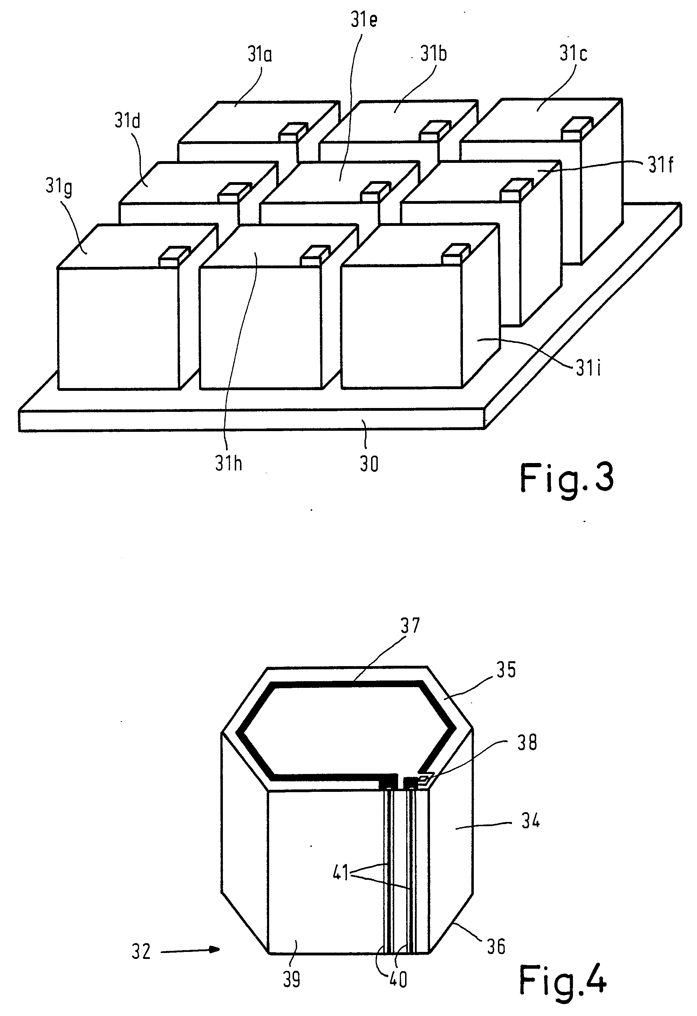

In Fig. 3 ist eine Meßvorrichtung dargestellt, bei der auf einem Grundträger 30, z.B. einer Kunststoffplatte, verschiedene Gradiometerträger 31a bis i durch Klebung aufgebracht sind. Der Klebstoff sollte ebenfalls so gewählt werden, daß eine Lösung eines Gradiometerträgers 31 vom Grundträger 30 möglich ist. Durch die Lösbarkeit der Gradiometerträger 31a bis i und der auf ihnen befestigten SQUIDS wird bei einem Defekt einer Gradiometerspule bzw. eines SQUIDS ein leichter Austausch möglich.

Eine zweite Ausführungsform eines Gradiometerträgers 32, dessen Körper 34 einen sechseckigen Querschnitt aufweist, ist in Fig. 4 dargestellt. Auf den Basisflächen 35 und 36 mit sechseckigem Umfang sind sechseckförmige Gradiometerspulen 37 aufgebracht. In einem kleinen Bereich außerhalb der Spulen 37 ist die Einkoppelspule 38 angebracht. Auf die Spule 38 ist in ähnlicher Weise, wie das in Fig. 2 dargestellt ist, eine Isolationsschicht aufgebracht, auf die die Platte mit dem SQUID und der Modulationsspule aufgeklebt ist. Auf einer Seitenfläche des Körpers 34 sind in zwei eingefrästen V-Nuten 40 Verbindungsleitungen 41 aus supraleitendem Draht, z.B. Niob-Draht, eingeklebt, welche die beiden Gradiometerspulen 37 verbinden.

Bei der Herstellung eines solchen Gradiometerträgers 32 gemäß Fig. 4 werden zunächst in die Seitenfläche 39 des Körpers 34 Nuten 40 geschnitten, z.B. gefräst, und in diese supraleitende Verbindungsleitungen 41 eingebracht. Im folgenden Schritt werden die beiden Basisflächen 35 und 36 poliert und anschließend in einem Planarlithographie-Schritt die supraleitenden Dünnschicht-Spulen hergestellt. Danach wird eine Isolationsschicht aufgebracht und anschließend die Platte mit dem in Photolithographie-Technik aufgebrachten-SQUID und der Modulationsspule aufgeklebt.

Zur Erreichung einer guten Kompensation von homogenen Magnetfeldern sollte auf der Basisfläche 36 ebenfalls eine ähnliche supraleitende Struktur angebracht werden, die genauso wie die Spule 38 hergestellt und die nicht mit den anderen Elementen verbunden ist.

Eine Meßvorrichtung mit den auf einen Grundträger aufgebrachten Gradiometerträgern wird auf der vorgegebenen in der Regel kreisrunden Fläche des Kyrostatsystems plaziert. Durch Verwendung von Gradiometerträgern mit sechseckigem Querschnitt ist es möglich, besonders viele Gradiometer auf dieser vorgegebenen Kreisfläche anzuordnen.

**Ansprüche**

1. Vorrichtung zur mehrkanaligen Messung schwacher Magnetfelder
mit einer jedem Kanal zugeordneten, auf einem Grundträger (30) angebrachten Anordnung aus einem supraleitenden Quanten-Interferenz-Element (SQUID) (6, 27), aus einem durch mindestens eine zur Erfassung des magnetischen Feldes dienenden Gradiometerspule (8, 12, 15, 16, 37), aus mindestens einer zur Einkopplung des Feldes in das SQUID dienenden Einkoppelspule (9, 19, 38) aus supraleitenden Verbindungsleitungen (10, 17, 18, 41) zwischen Gradiometerspule und Einkoppelspule und aus einer Modualationsspule (7, 26), wobei wenigstens die Gradiometerspule, die Einkoppelspule und das SQUID aus Dünnfilmstrukturen gebildet sind, und
mit einer zur Auswertung der von den SQUIDS in jedem Kanal erzeugten Signale dienenden Auswerteeinrichtung (11), dadurch gekennzeichnet, daß für jeden Kanal eine gesonderte Platte (29) vorgesehen ist, auf der das SQUID (6, 27) und die Modulationsspule (7, 26) aufgebracht sind, daß die für jeden Kanal vorgesehene Anordnung aus Gradiometerspule (8, 12, 15, 16, 37), Verbindungsleitungen (10, 17, 18, 41) und Einkoppelspule (9, 19, 38) auf jeweils einem gesonderten Gradiometerträger (12, 32) aufgebracht ist und daß eine Platte auf einem Gradiometerträger angeordnet ist und die einzelnen Gradiometerträger mit dem Grundträger (30) verbunden sind.

2. Vorrichtung nach Anspruch 1,
dadurch gekennzeichnet, daß die Platte (29) lösbar mit dem Gradiometerträger (12, 32) und die Gradiometerträger lösbar mit dem Grundträger (30) verbunden sind.

3. Vorrichtung nach Anspruch 2,
dadurch gekennzeichnet, daß die lösbaren Verbindungen Klebeverbindungen sind.

4. Vorrichtung mit einem Gradiometer erster oder höherer Ordnung nach Anspruch 1, 2 oder 3,
dadurch gekennzeichnet, daß die Gradiometerspulen (15, 37), die einen gemeinsamen Wicklungssinn haben, auf einer Basisfläche (21, 35) des Gradiometerträgers (12, 32) und die Gradiometerspulen (16) mit gegensinnigem Wicklungssinn auf einer gegenüberliegenden Basisfläche (22, 36) des Gradiometerträgers angeordnet sind.

5. Vorrichtung nach Anspruch 4,
dadurch gekennzeichnet, daß die Einkoppelspule (19) auf einer die Basisflächen (21, 22) verbindenden Seitenfläche (20) des Gradiometerträgers (12) angeordnet ist.

6. Vorrichtung nach Anspruch 4,
dadurch gekennzeichnet, daß die Einkoppelspule (38) auf einer Basisfläche (35) des Gradiometerträgers angebracht ist, auf der eine feldseitige Gradiometerspule (37) angeordnet ist.

7. Vorrichtung nach Anspruch 6,
dadurch gekennzeichnet, daß die Verbindungsleitungen zwischen den Gradiometerspulen (37) supraleitende Drähte (41) sind, die in Nuten (40) einer Seitenfläche (39) des Gradiometerträgers (32) verlaufen, welche die beiden gegenüberliegenden Basisflächen (35, 36) mit den Gradiometerspulen (37) verbindet.

8. Vorrichtung nach einem der Ansprüche 6 oder 7,
dadurch gekennzeichnet, daß auf der keine Einkoppelspule (38) aufweisenden Basisfläche (36) eine der Einkoppelspule gegenüberliegende supraleitende Leitungsstruktur aufgebracht ist, die im wesentlichen der Struktur der Einkoppelspule entspricht.

9. Vorrichtung nach einem der Ansprüche 4, 6, 7 oder 8,
dadurch gekennzeichnet, daß der Gradiometerträger (32) einen sechseckigen Querschnitt aufweist.

10. Vorrichtung nach einem der vorhergehenden Ansprüche,
dadurch gekennzeichnet, daß zwischen Gradiometerträger (14) und Einkoppelspule (19) und auf der Seite der Platte (29), die dem Gradiometerträger abgewendet ist, jeweils supraleitende Abschirmungen (24, 28) angeordnet sind.

11. Verfahren zur Herstellung einer Vorrichtung nach Anspruch 5,
dadurch gekennzeichnet, daß zunächst auf gegenüberliegenden Basisflächen (21, 22) des Gradiometerträgers (12) die Gradiometerspulen (15, 16) und auf einer Seitenfläche (20) die Verbindungsleitungen (17, 18) und die Einkoppelspule (19) photolithographisch angebracht werden und anschließend nach Aufbringen einer Isolationsschicht (25) auf die Seitenfläche eine Platte (26), welche das in Photolithographie-Technik aufgebrachte SQUID und die Modulationsspule enthält, aufgeklebt wird.

12. Verfahren zur Herstellung einer Vorrichtung nach Anspruch 6,
dadurch gekennzeichnet, daß zunächst in eine Seitenfläche (39) des Körpers Nuten (40) geschnitten werden und in diese Nuten supraleitende Drähte (41) eingebracht werden, daß anschließend nach Polierung der beiden gegenüberliegenden, die Seitenfläche mit den Nuten verbindenden Basisflächen (35, 36) die Gradiometerspulen (37) photolithographisch aufgebracht werden und daß nach Aufbringen einer Isolationsschicht auf die Basisflächen eine Platte, welche das in Photolithographie-Technik aufgebrachte SQUID und die Modulationsspule enthält, aufgeklebt wird.

a.)

b.)

Fig.1

Fig.2

31e
31a
31b
31c
31d
31f
31g
31i
31h
30

Fig.3

37
35
38
34
41
36
32
39
40

Fig.4